# EUROPEAN PATENT SPECIFICATION

(11) **EP 1 692 750 B1**
(45) Date of publication and mention of the grant of the patent: **27.01.2010**
(21) Application number: 04800552.4
(22) Date of filing: 01.11.2004
(51) Int. Cl.: H01S 3/223

(54) **LASER OUTPUT LIGHT PULSE STRETCHER**
LASERAUSGANGS-LICHTIMPULS-STRECKER
EXTENSEUR D'IMPULSIONS LUMINEUSES D'EMISSION LASER

(30) Priority: 13.11.2003 US 712545; 18.05.2004 US 847799
(43) Date of publication of application: 23.08.2006
(73) Proprietor: Cymer, Inc., San Diego, CA 92127-2413 (US)
(72) Inventor: SMITH, Scot, T., Winter Springs, FL 32708 (US); ERSHOV, Alexander, I., San Diego, CA 92127 (US); LUKASHEV, Alexei, San Diego, CA 92130 (US)
(74) Representative: Grünecker, Kinkeldey, Stockmair & Schwanhäusser Anwaltssozietät
(86) International application number: PCT/US2004/036371
(87) International publication number: WO 2005/050795

(56) References cited:
- US-A- 5 157 684
- US-A- 5 592 326
- US-A1- 2003 043 876
- US-A1- 2003 117 601
- US-B1- 6 389 045
- US-B1- 6 442 186

## Description

### FIELD OF THE INVENTION

The present invention relates to high peak power short pulse duration gas discharge laser systems, e.g., excimer or other fluorine gas discharge lasers, e.g., molecular fluorine gas discharge laser systems, utilized, e.g., in applications such as integrated circuit lithography, wherein downstream optics may be severely damages or suffer shortened lifetimes due to optical fluence damage mechanisms driven more by peak power than total integrated power of the light passing through the downstream optical element.

### BACKGROUND OF THE INVENTION

It is also known that spatial coherence is a factor in laser light sources, e.g., excimer and other gas discharge laser light sources, e.g., molecular fluorine laser light sources properly performing according to specification in, e.g., the use of such light, e.g., in the DUV range, for, e.g., exposure of photoresists on integrated circuit wafers. The makers of such integrated circuit lithography tools are demanding tighter and tighter specifications for spatial coherence. Some lasers manufactured by applicants' assignee, e.g., XLA lasers, are borderline passing tests for spatial coherence according to current practice and may become even more susceptible to being out of specification in the future as specifications are defined more tightly. In the past the metrology used to define spectral coherence was to, e.g., find a point with maximum interference fringe contrast in the laser beam and use that as a measure of spatial coherence. However this data point does not represent the property of coherence of the whole beam. Applicants have, therefore, determined that a better means of measuring beam spatial coherence is needed and propose such a method in the present application.

A system according to the preamble of claim 1 is derivable from US-A-2003/004 3876.

### SUMMARY OF THE INVENTION

According to the invention an apparatus is provided as defined in claim 1. Further, a method according to the invention is provided with the features of claim 5.

The apparatus and method for providing a high peak power short pulse duration gas discharge laser output pulse is disclosed which comprises a pulse stretcher which comprises a laser output pulse optical delay initiating optic diverting a portion of the output laser pulse into an optical delay having an optical delay path and comprising; a plurality of confocal resonators in series aligned to deliver an output of the optical delay to the laser output pulse optical delay initiating optic. The plurality of confocal resonator may comprise four confocal resonators comprising a twelve pass four mirror arrangement. Each of the plurality of confocal resonators may comprise a first concave spherical mirror having a radius of curvature and a second concave spherical mirror having the same radius of curvature and separated by the radius of curvature. The pulse stretcher comprises a first confocal resonator cell which comprises: a first concave spherical mirror having a radius of curvature receiving an input beam from the laser output pulse optical delay initiating optic comprising the portion of the output laser pulse at a first point on a face of the first concave spherical mirror and generating a first reflected beam; a second concave spherical mirror having the same radius of curvatures and separated from the first concave spherical mirror by the radius of curvature and receiving the first reflected beam at a first point on a face of the second concave spherical mirror and generating a second reflected beam incident on a second point on the face of the first concave spherical mirror, the second reflected beam being reflected by the first concave spherical mirror from the second point on the first mirror to form an output beam from the first confocal resonator cell; and, a second confocal resonator cell receiving the output beam of the first confocal resonator cell as an input beam of the second confocal resonator cell. The apparatus and method may form part of a beam delivery unit and may be part of an integrated circuit lithography lights source or an integrated circuit lithography tool. The apparatus- and method may comprise a plurality, e.g., two pulse stretchers in series and may include spatial coherency metrology.

### BRIEF DESCRIPTION OF THE DRAWINGS

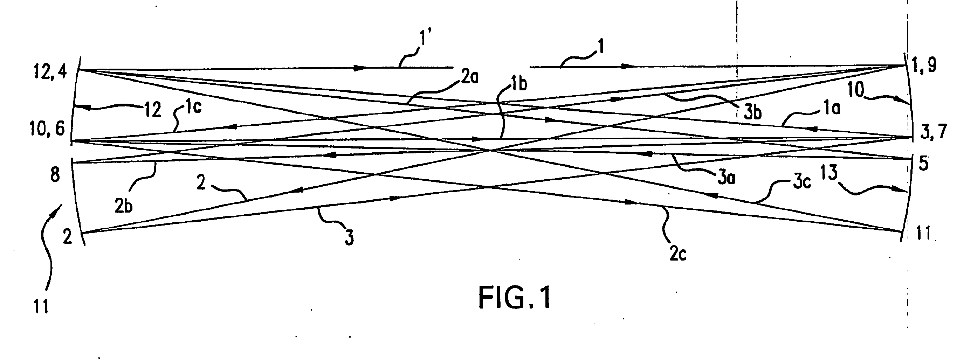

FIG. 1 shows a partially schematic cross-sectional view of a pulse stretcher according to aspects of an embodiment of the present invention;
FIG. 2 shows a partially schematic perspective view of the pulse stretcher according to FIG. 1;
FIG.' s 3-5 show aspects of the operation according to an embodiment of the present invention showing, e.g., the tilt tolerance aspect of an embodiment of the present invention;
FIG. 6 illustrates partially schematically in cross section, e.g., the tilt tolerance of the pulse stretcher according to FIG.' s 1-2.
FIG. 7 shows a measurement of the two dimensional spatial coherence of an output laser pulse passed through two pulse stretchers in series according to aspects of an embodiment of the present invention;
FIG. 8 shows a measurement of the two dimensional spatial coherence of an output laser pulse passed through a single pulse stretcher according to aspects of an embodiment of the present invention;
FIG. 9 shows a measurement of the two dimensional spatial coherence of an output laser pulse without any pulse stretching according to an aspect of an embodiment of the present invention; and
FIG. 10 shows a two dimensional measurement of the intensity distribution of an output laser pulse according to an aspect of an embodiment of the present invention.

### DETAILED DESCRIPTION OF PREFERRED EMBODIMENTS

According to aspects of an embodiment of the present invention applicant has designed an optical pulse stretcher for a laser light source, e.g., a gas discharge laser light source, e.g., a KrF or ArF or molecular fluorine gas discharge laser, e.g., for use in-integrated-circuitry lithography- illumination, which has a long optical delay, but is constrained to have a practical physical length, e.g., less than about 244 cm (8 feet), e.g., in order to be mounted on existing laser frames or contained within a beam delivery unit and fit, e.g., in a fabrication facility clean room sub-floor room. According to aspects of an embodiment of the present invention, the pulse stretcher may be, e.g., a multi-passing system with a minimum number of optics, e.g., four, consistent with proper operation. This, in addition, e.g., minimizes the number of adjustments necessary to align a system, and according to aspects of an embodiment of the present invention the system is designed to allow for a considerable amount of misalignment over systems of the prior art. According to an aspect of an embodiment of the present invention the pulse stretcher comprises, e.g., a unique optical design that produces 12 passes with only 4 mirrors. Such a pulse stretcher is capable of, e.g., an optical pulse stretching having, e.g., an 80 ns delay from a physical length of about 2 meters and a total of 4 mirrors. According to aspects of an embodiment of the present invention also, the pulse stretcher disclosed, e.g., does not suffer the focusing problems of, e.g., a Herriott Cell nor the re-entry and symmetry problems of, e.g., a White Cell.

What is so remarkable about aspects of an embodiment of the present invention, in addition to its space efficiency is its stability. The design is so stable that it may require no adjustments for alignment. According to aspects of an embodiment of the present invention stability can be derived, e.g., from the fact that the design is essentially 4 confocal resonators, having, e.g., the re-entry characteristic of a confocal resonator. According, e.g., the beam will retrace its path no matter what the angle orientation exists between the two mirrors forming, e.g., the respective confocal resonator, as long as the beam intercepts the respective next mirror in the respective confocal resonator. This concept can be most easily identified by examining one section of the layout as shown in FIG.'s 3-6. Turning first to FIG.' s 1 and 2, however, there is shown a pulse stretcher 18 according to aspects of an embodiment of the present invention.

The pulse stretcher 18 may comprise, e.g., four focusing mirrors, e.g., concave spherical mirrors 20, 21, 22, 23, which may be, e.g., 10 cm in diameter, e.g., for handling adequately a beam size of e.g., 1.2 cm x 1.2 cm. Each of the mirrors 20, 21, 22 and 23 is separated by a radius of curvature of the spherical mirror preceding it in a respective confocal resonator cell and may have, e.g., a radius of curvature of, e.g., about 1.6 - 2 meters. In operation, e.g., the beam 1 can enter the delay path formed by the mirrors 20, 21, 22, 23 through a beam splitter (not shown in FIG.'s 1 and 2 for clarity reasons) and be incident at a first point 1 on the mirror 20. From point 1 on the mirror the reflected beam 2 is incident on point 2 on mirror 21, and from there, the reflected beam 3 returns to mirror 20 at point three. From point 3 on mirror 20, the reflected beam 1a is incident on point 4 on mirror 22 and from there the reflected beam 2a is incident on point 5 on mirror 23 and the reflected beam from point 5 on mirror 23 is returned to mirror 22 as reflected beam 3a incident on point 6 on mirror 22.

A third confocal resonator cell is then set up as the beam reflected from point 6 on mirror 22, beam 1b reflected to point 7 on mirror 20 and from there is reflected as beam 2b incident on point 8 on mirror 21 and then returned to mirror 20 at point 9 on mirror 20 as beam 3b. The reflected beam from point 9 on mirror 20, beam, 1c is incident on point 10 on mirror 22 and reflected from there as beam 2c to point 11 on mirror 23 and from there, reflected beam 3c is incident on point 12 on mirror 22 which is aligned to return reflected beam 1' to the beam splitter (not shown in FIG.'s 1 and 2).

Turning now to FIG.s 3-6 it can be seen that no matter what the angle orientation of the mirrors 20, 21, 22, 23 in a respective confocal resonance cell, the beam will always come back to the same point 12 on mirror 22. FIG.s 3-6 illustrate the effect within a single confocal resonance cell of misalignment from perfect alignment, e.g., as illustrated in FIG.'s 1-2. Because of, e.g., this property, the 12 pass design 18 will always be aligned as long as the mirrors, e.g., mirrors 20, 21, 22, 23 are positioned well enough to redirect the beam from a first mirrors in a respective confocal resonator cell to the correct opposing mirror. Therefore, the angular allowance of the system is driven by the size of the mirrors and the size of the beam. This also means, e.g., that the design is almost completely immune to, e.g., initial misalignment or, e.g., vibration problems that cause relative movements between the mirrors, e.g., mirrors 20, 21, 22 and 23, provided that the variations are small enough as to not to redirect the beam off the respective opposing mirror.

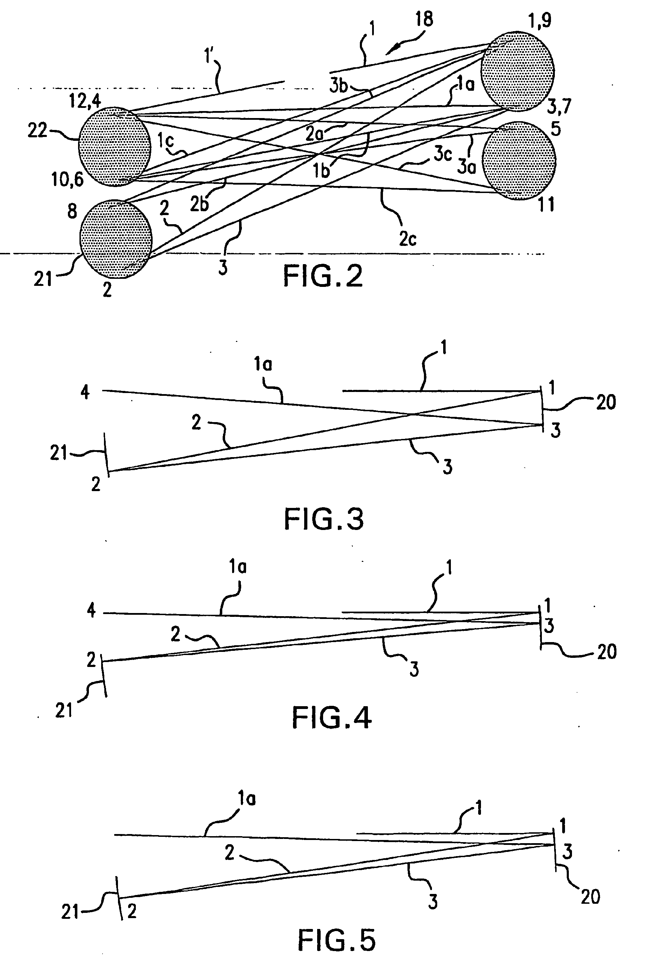

Turning now to FIG. 3 there is shown, e.g., a first of the confocal resonance cells according to FIG.s 1 and 2, showing, e.g., beams 1, 2 and 3 in a first confocal resonance cell as shown, e.g, in FIG.' s 1 and 2, e.g., with the mirrors 20 and 21 aligned so that, e.g., the full extent of mirror 20 is used to separate points 1 and 3 and showing the reflection from point 2 on mirror 21 returning to point 3 on mirror 2o, from which it is reflected to point 4 on mirror 22 (not shown in FIG.'s 3-5).

Turning to FIG. 4 three is shown according to an aspect of an embodiment of the present invention the effect of, e.g., a small misalignment of mirror 20, e.g., a 1.5° tilt, such that, e.g., the point 2 on mirror 21 to which beam 2 travels from point 1 on mirror 20, due to the misalignment is displaces almost completely across the face of the mirror 21, but remaining on the face of the mirror 21. As can be seen, the respective beam 3, incident on point 3 of mirror 20 is also reflected to a point 3 that is displaced across the face of the mirror 20 from that shown e.g., in FIG.' s 1-3, but as can also be seen, the beam 1a reflecting from point 3 on mirror 20 to point 4 on mirror 22 remains incident on a point 4 on mirror 22 that is essentially the same as illustrated in FIG.'s 1-3, despite the misalignment of mirror 20.

Turning to FIG. 5, three is illustrated schematically, e.g., the effect of a misalignment of mirror 21 according to aspects of an embodiment of the present invention wherein the beam 2 is incident on mirror 21 at a point 2 displaces across the face of mirror 21, also displacing the point 3 on mirror, similarly to FIG. 4, but with the beam 1a reflected from point 3 on mirror 20 in FIG. 5 again returning to the proper point 4 on mirror 22 (not shown in FIG. 5.)

FIG.' s 4 and 5 illustrate, e.g., that despite misalignment of mirror 20 with respect to mirror 21, which can include misalignment of both from the perfect alignment, illustrated schematically in FIG.' s 1-3, the beam reflects back upon itself and so long as it remains within the confines of the surface of the mirror 20 (the first mirror of the respective confocal resonator) the exit beam from the respective confocal resonator will arrive at the proper place on the next mirror in sequence, e.g., mirror 22 (not shown in FIG.' s 4 and 5).

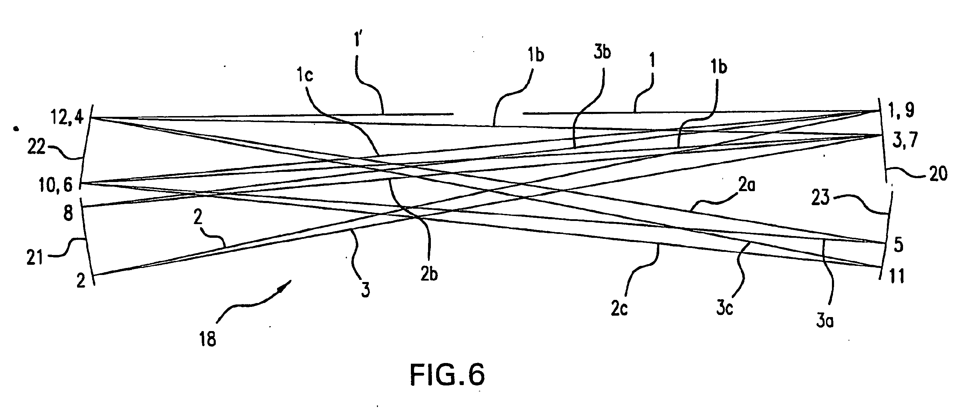

Turning now to FIG. 6 there is shown schematically the operation of the entire pulse stretcher according to an aspect of an embodiment of the present invention with, e.g., a slight tilt in a mirror 20, 21, 22 or 23, e.g., mirror 21. Fig. 6 shows that despite the misalignment the last beam 1' remains perfectly aligned with the beam splitter (not shown) output of the delay path for the pulse stretcher 18 according to aspects of an embodiment of the present invention.

In operation a single pulse stretcher of the type described according to aspects of an embodiment of the present invention may stretch a typical excimer or other fluorine gas discharge laser, e.g., a molecular fluorine gas discharge laser, having a pulse duration of the output laser pulse of on the order of about 40 ns having, e.g., a T_{IS} of on the order of about, e.g., 8 ns, to a pulse having several peaks not greater than, e.g., about 40% of the input peak power to the pulse stretcher 18 according to aspects of an embodiment of the present invention, and having, e.g., a T_{IS} of on the order of about 45 ns.

It will also be understood, that increasing the radius of curvature of the mirrors 20, 21, 22 and 23 can increase by the achievable pulse stretching and T_{IS}, at the expense of some increase in overall length of the pulse stretcher 18 according to aspects of an embodiment of the present invention and also larger mirror size and, therefore, a larger housing footprint transversely of the overall pulse stretcher length. According to another aspect of an embodiment of the present invention, a method of scanning the laser beam and calculating weighted average of the spatial coherence is proposed, e.g., for measuring more accurately the spatial coherence of an output laser beam pulse as is pertinent to proper performance of the output laser beam pulse in properly serving the function of, e.g., an integrated circuit lithography tool light source, e.g., a DUV light source. Implementation of this method revealed interesting aspects of laser output light pulse beam profiles, e.g., in regard to spatial coherence, e.g., for XLA beam spatial coherence profiles. Applicants have discovered that an aspect of using, e.g., a beam stretcher according to aspects of an embodiment of the present invention can provide very beneficial output laser pulse beam spatial coherency properties. It is most desirable to limit spatial coherency.

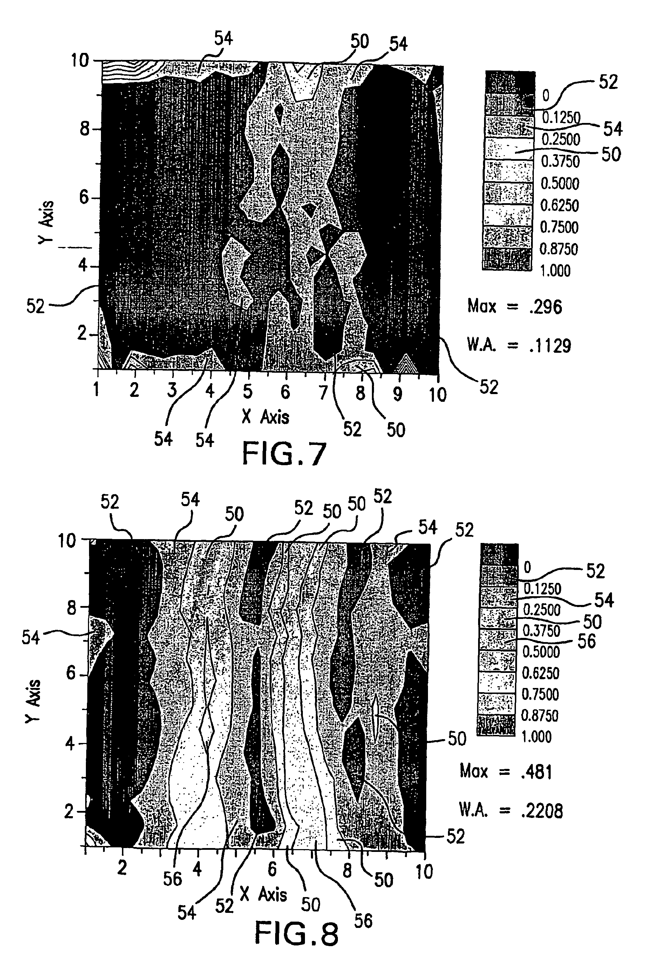

Utilizing, e.g., two pairs of pin holes, and an X-Y automated scanning setup (not shown) along with imaging optics (not shown) and a photo-diode array ("PDA"), and along with computer control to, e.g., acquire and analyze the data, applicants have reviewed the spatial coherency in two dimensions of a beam that has not been passed through a pulse stretcher, a so-called Optical Pulse Stretcher ("OpuS") provided along with certain of applicants' assignee's products, e.g., XLA series products. This scanning means of estimation of output laser pulse coherence produced data illustrated, e.g., in FIG.' s 7-9, showing respectively the information regarding two dimensional beam coherency for, respectively an unstretched pulse, i.e., a pulse not passed through applicants' assignee's OpuS (FIG. 7), a pulse passed through a single stage pulse stretcher, e.g., applicants' assignee's OpuS, and an output laser pulse beam passed through a two stage Opus. Applicants' assignee's OpuS in addition to stretching the pulses to improve, e.g., T_{IS}, performs certain, e.g., optical flipping and rotating and the like, of the output laser pulse beam, with results indicated illustratively in FIG.' s 7-9.

**Table I**

| | XLA no OPuS | XLA one 2x OpuS (XLA100) | XLA two OpuS 4xOPuS (XLA105 | |
|---|---|---|---|---|
| Peak contrast | 0.58 | 0.48 | 0.30 | |
| Weighted Average | 0.37 | 0.22 | 0.11 | |
| | | | | |

As shown in FIG. 7, and listed in Table I, the output laser pulse has a peak contrast of about, e.g., 0.3, and a weighted average overall of about, e.g., 0.11. FIG. 7 shows that the horizontal and vertical coherency is low, with, e.g., most of the beam being in regions 52 (0-0.125) as indicated in the bar graph to the right of the illustration or region 54 ((0.125-0.250), with some small portions of the beam in region 50 (0.250-0.375), and some further still smaller portions in other ranges, which are due to boundary effects of the measurement setup. These measurements were taken with a 2X OpuS pulse stretcher and a 4x Opus pulse stretcher in place in the beam path.

Turning to FIG. 8 there is shown an illustration of the beam becoming more coherent, particularly as measured in the x-axis, including much more of the beam in range 50 (0.250-0.375) and also including still further areas in range 56 (0.375-0.500). These measurements were taken with only a 2X OpuS in place in the beam path.

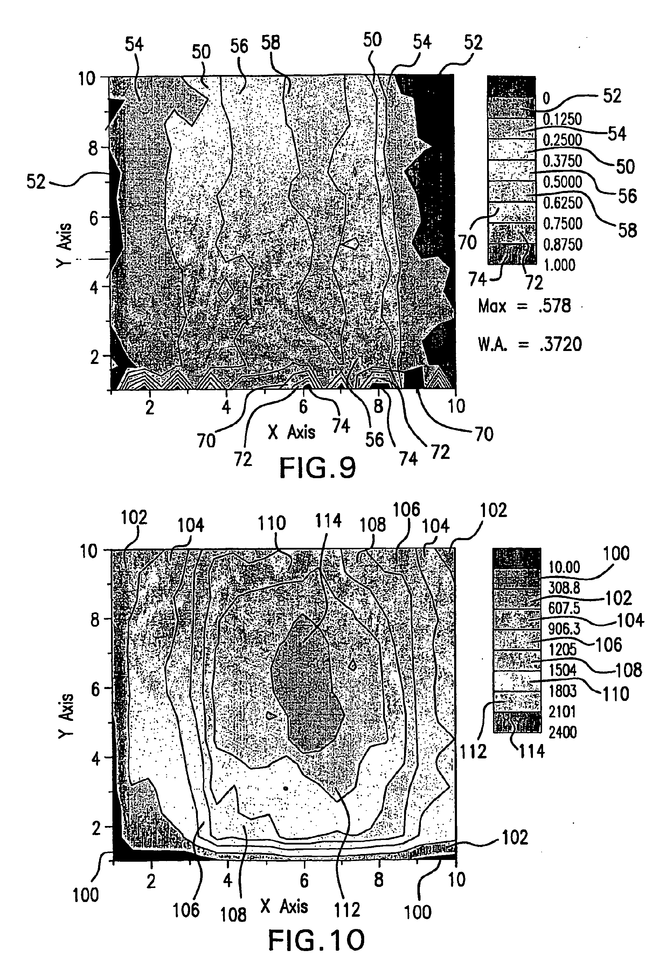

As shown in FIG. 9, the beam is even more coherent when both pulse stretchers are out of the beam path, now including a more definite distribution of more or less equal areas in the ranges 50-54 and distributed more or less symmetrically about the vertical centerline axis of the beam along the x-axis and further now including a significant portion in range 58 (0.500-0.625) with some small portions of the beam in the ranges 70 (0.625-0.750), 72 (0.750-0.875) and 74 (0.875-1.000). Coherency is being measured through the diffraction fringes set up by the beam passing through the pin holes across the beam profile, with the more coherent light in the laser beam resulting in more fringes and more contrast.

For the beam of FIG. 8, as indicated in Table I, the maximum contract increased to 0.48 and the overall weighted average increased to 0.22 and for FIG. 9, the maximum contract increased to 0.58 and the overall weighted average to 0.37. This amounts to, e.g., an almost one half increase in the maximum contrast and an almost two thirds decrease in overall weighted average.

As can be seen from the above, the pulse stretcher has not only the beneficial results of increasing pulse length and decreasing peak pulse intensity, resulting in higher T_{IS} but also is a very efficient reducer of spatial coherence in the output laser light beam.

Turning now to FIG. 10, there is shown a beam intensity profile in two dimensions, including, e.g., intensities ranging from 10-308.8 arbitrary units of scale, in region 100, generally around the periphery of the beam profile to 2101-2400 arbitrary units of scale (region 114) generally at the center of the beam profile, with regions 102 (308.8-607.5), 104 (607.5-906.3), 106 (906.3-1205), 108 (1205-1504), 108 (1504-1803), 112 (1803-2101) and 114 (2101-2400) generally from the periphery to the center of the beam profile.

It will be understood by those skilled in the art that many changes and modifications may be made to the present invention without departing from the scope of the appended claims and that the appended claims should not be limited in scope to the particular aspects of preferred embodiments disclosed in the present application.

## Claims

1. A high peak power short pulse duration gas discharge laser system producing a laser output pulse comprising:
a pulse stretcher comprising:
a laser output pulse optical delay initiating optic diverting a portion (1) of the output laser pulse as an input beam into an optical delay having an optical delay path:
**characterized in that:**
said optical delay comprises:
a plurality of confocal resonator cells (1,2,3, 4,5,6,7,8,9,10,11,12) in series aligned to deliver an output of the optical delay to the laser output pulse optical delay initiating optic;
wherein a first confocal resonator cell (1,2,3) of the plurality of confocal resonator cells (1,2,3,4,5,6,T,8,9,10,11,12) comprises
a first concave spherical mirror (20) having a radius of curvature receiving the input beam from the laser output pulse optical delay initating optic, comprising the portion (1) of the output laser pulse, at a first point (1) on a face of the first concave spherical mirror (20) and generating a first deflected beam (2);
a second concave spherical mirror (21) having the same radius of curvature and separated from the first concave spherical mirror (20) by the radius of curvature and receiving the first reflected beam (2) at a first point (2) on a face of the second concave spherical mirror (20) and generating a second reflected beam (3) incident on a second point (3) on the face of the first concave spherical mirror (20), the second reflected beam (3) being reflected by the first concave spherical mirror (20) from the second point (3) on the first mirror (20) to form an output beam (1a) from the first confocal resonator cell (1,2,3); and,
a second confocal resonator cell (4,5,6) receiving the output beam (1 a) of the first confocal resonator cell (4,5,6) as an input beam of the second confocal resonator cell (4,5,6).

2. The apparatus of claim 1 further comprising:
the plurality of confocal resonator cells comprises four confocal resonator cells comprising a twelve pass four mirror arrangement.

3. The apparatus of claim 1 or 2 further comprising:
each of the plurality of confocal resonator cells (1,2,3,4,5,6,7,8,9,10,11,12) comprises a first concave spherical mirror (20, 22, 20, 22) having a radius of curvature and a second concave spherical mirror (21, 23, 21, 23) having the same radius of curvature and separated by the radius of curvature.

4. The apparatus of any one of claims 1 - 3 further comprising:
a second pulse stretcher comprising
a second laser output pulse optical delay initiating optic diverting a portion of the output of the first pulse stretcher into a second optical delay having an optical delay path and comprising:
a second plurality of confocal resonator cells in series aligned to deliver an output of the second optical delay to the second laser output pulse optical delay initiating optic.

5. A method of providing a high peak power short pulse duration gas discharge laser output pulse comprising stretching the output pulse
**characterized in that:**
said stretching the output pulse comprises;diverting a portion of the output laser pulse into an optical delay path (1,2,3, 4,5,6,7,8,9,10,11,12) comprising:
a plurality of confocal resonator cells (1,2,3, 4,5,6,7,8,9, 10,11,12) in series delivering the output of the optical delay path to the laser output pulse optical delay initiating optic and combining it with the laser output pulse; wherein stretching the output pulse further comprises:
utilizing a first confocal resonator cell of the plurality of confocal resonator cells comprising:
a first concave spherical mirror means (20) having a radius of curvature for receiving an input beam (1) from the laser output pulse optical delay initiating optic, comprising the portion of the output laser pulse at a first point (1) on a face of the first concave spherical mirror means (20) and generating a first reflected beam (2);
a second concave spherical mirror means (21) having the same radius of curvature and separated from the first concave spherical mirror means (20) by the radius of curvature for receiving the first reflected (2) at a first point (2) on a face of the second concave spherical mirror means (21) and for generating a second reflected beam (3) incident on a second point (3) on the face of the first concave spherical mirror means (20), the second reflected beam (3) being reflected by the first concave spherical mirror means (20) from the second point (3) on the first mirror (20) to form an output beam (1a) from the first confocal resonator cell (1,2,3); and,
a second confocal resonator cell means (4,5,6) for receiving the output beam (1a) of the first confocal resonator cell means (1,2,3) as an input beam of the second confocal resonator cell means (4,5,6).

6. The method of claim 5 further comprising: the plurality of confocal resonator cells comprises four confocal resonator cells (1,2,3,4,5,6,7,8,9,10,11,12) comprising a twelve pass four mirror (20, 21, 22, 23) arrangement.

7. The method of claims 5 or 6 further comprising: each of the plurality of confocal resonator cells (1,2,3,4,5,6,7,8,9,10,11,12) comprises a first concave spherical mirror (20, 22, 20, 22) having a radius of curvature and a second concave spherical mirror (21, 23, 21, 23) having the same radius of curvature and separated by the radius of curvature.

## Patentansprüche

1. Gasentladungs-Lasersystem mit hoher Spitzenleistung und kurzer Impulsdauer, das einen Laserausgangsimpuls erzeugt und umfasst:
einen Impulsdehner, der umfasst:
eine Optik zum Auslösen optischer Verzögerung eines Laserausgangsimpulses, die einen Teil (1) des Ausgangslaserimpulses als einen Eingangsstrahl in ein optisches Verzögerungsglied umleitet, das einen optischen Verzögerungsweg hat,
**dadurch gekennzeichnet, dass**
das optische Verzögerungsglied umfasst:
eine Vielzahl von konfokaler Resonatorzellen (1, 2, 3, 4, 5, 6, 7, 8, 9, 10, 11, 12), die in Reihe ausgerichtet sind, um einen Ausgang des optischen Verzögerungsgliedes der Optik zum Auslösen optischer Verzögerung des Laserausgangsimpulses zuzuleiten;
wobei eine erste konfokale Resonatorzelle (1, 2, 3) der Vielzahl konfokaler Resonatorzellen (1, 2, 3, 4, 5, 6, 7, 8, 9, 10, 11, 12) umfasst:
einen ersten konkaven sphärischen Spiegel (20), der einen Krümmungsradius hat und den Eingangsstrahl von der Optik zum Auslösen optischer Verzögerung des Laserausgangsimpulses, der den Teil (1) des Ausgangs-Laserimpulses umfasst, an einem ersten Punkt (1) an einer Fläche des ersten konkaven sphärischen Spiegels (20) empfängt und einen ersten reflektierten Strahl (2) erzeugt;
einen zweiten konkaven sphärischen Spiegel (21), der den gleichen Krümmungsradius hat und von dem ersten konkaven sphärischen Spiegel (20) um den Krümmungsradius getrennt ist und den ersten reflektierten Strahl (2) an einem ersten Punkt (2) an einer Fläche des zweiten konkaven sphärischen Spiegels (20) empfängt und einen zweiten reflektierten Strahl (3) erzeugt, der auf einen zweiten Punkt (3) an der Fläche des ersten konkaven sphärischen Spiegels (20) auftrifft, wobei der zweite reflektierte Strahl (3) durch den ersten konkaven sphärischen Spiegel (20) von dem zweiten Punkt (3) an dem ersten Spiegel (20) reflektiert wird, um einen Ausgangsstrahl (1a) von der ersten konfokalen Resonatorzelle (1, 2, 3) zu erzeugen; und
eine zweite konfokale Resonatorzelle (4, 5, 6), die den Ausgangsstrahl (1a) der ersten konfokalen Resonatorzelle (4, 5, 6) als einen Eingangsstrahl der zweiten konfokalen Resonatorzelle (4, 5, 6) empfängt.

2. Vorrichtung nach Anspruch 1,
wobei die Vielzahl konfokaler Resonatorzellen vier konfokale Resonatorzellen umfasst, die eine Vier-Spiegel-Anordnung mit zwölf Durchgängen bilden.

3. Vorrichtung nach Anspruch 1 oder 2,
wobei jede der Vielzahl konfokaler Resonatorzellen (1, 2, 3, 4, 5, 6, 7, 8, 9, 10, 11, 12) einen ersten konkaven sphärischen Spiegel (20, 22, 20, 22), der einen Krümmungsradius hat, und einen zweiten konkaven sphärischen Spiegel (21, 23, 21, 23) umfasst, der den gleichen Krümmungsradius hat und um den Krümmungsradius getrennt ist.

4. Vorrichtung nach einem der Ansprüche 1 - 3, die des Weiteren umfasst:
einen zweiten Impulsdehner, der umfasst:
eine zweite Optik zum Auslösen optischer Verzögerung des Laserausgangsimpulses, die einen Teil des Ausgangs des ersten Impulsdehners in ein zweites optisches Verzögerungsglied umleitet, das einen optischen Verzögerungsweg hat, und die umfasst:
eine zweite Vielzahl konfokaler Resonatorzellen, die in Reihe ausgerichtet sind, um einen Ausgang des zweiten optischen Verzögerungsgliedes der zweiten Optik zum Auslösen optischer Verzögerung des Laserausgangsimpulses zuzuleiten.

5. Verfahren zum Erzeugen eines Gasentladungs-Laserausgangsimpulses mit hoher Spitzenleistung und kurzer Impulsdauer, das Dehnen des Ausgangsimpulses umfasst,
**dadurch gekennzeichnet, dass**
das Dehnen des Ausgangsimpulses Umleiten eines Teils des Ausgangslaserimpulses in einen optischen Verzögerungsweg (1, 2, 3, 4, 5, 6, 7, 8, 9, 10, 11, 12) umfasst, der umfasst:
eine Vielzahl konfokaler Resonatorzellen (1, 2, 3, 4, 5, 6, 7, 8, 9, 10, 11, 12) in Reihe, die den Ausgang des optischen Verzögerungsweges der Optik zum Auslösen optischer Verzögerung des Laserausgangsimpulses zuleiten und ihn mit dem Laserausgangsimpuls kombinieren, wobei Dehnen des Ausgangsimpulses des Weiteren umfasst:
Einsetzen einer ersten konfokalen Resonatorzelle der Vielzahl konfokaler Resonatorzellen, die umfasst:
eine erste konkave sphärische Spiegeleinrichtung (20), die einen Krümmungsradius hat und den Eingangsstrahl von der Optik zum Auslösen optischer Verzögerung des Laserausgangsimpulses, der den Teil (1) des Ausgangs-Laserimpulses umfasst, an einem ersten Punkt (1) an einer Fläche der ersten konkaven sphärischen Spiegeleinrichtung (20) empfängt und einen ersten reflektierten Strahl (2) erzeugt;
eine zweite konkave sphärische Spiegeleinrichtung (21), die den gleichen Krümmungsradius hat und von der ersten konkaven sphärischen Spiegeleinrichtung (20) um den Krümmungsradius getrennt ist, um den ersten reflektierten Strahl (2) an einem ersten Punkt (2) an einer Fläche der zweiten konkaven sphärischen Spiegeleinrichtung (20) zu empfangen und einen zweiten reflektierten Strahl (3) zu erzeugen, der auf einen zweiten Punkt (3) an der Fläche der ersten konkaven sphärischen Spiegeleinrichtung (20) auftrifft, wobei der zweite reflektierte Strahl (3) durch die erste konkave sphärische Spiegeleinrichtung (20) von dem zweiten Punkt (3) an dem ersten Spiegel (20) reflektiert wird, um einen Ausgangsstrahl (1 a) von der ersten konfokalen Resonatorzelle (1, 2, 3) zu erzeugen; und
eine zweite konfokale Resonatorzelleneinrichtung (4, 5, 6) zum Empfangen des Ausgangsstrahls (1a) der ersten konfokalen Resonatorzelleneinrichtung (1, 2, 3) als einen Eingangsstrahl der zweiten konfokalen Resonatorzelleneinrichtung (4, 5, 6).

6. Verfahren nach Anspruch 5,
wobei die Vielzahl konfokaler Resonatorzellen vier konfokale Resonatorzellen (1, 2, 3, 4, 5, 6, 7, 8, 9, 10, 11, 12) umfasst, die eine Vier-Spiegel-Anordnung (20, 21, 22, 23) mit zwölf Durchgängen bilden.

7. Verfahren nach Anspruch 5 oder 6,
wobei jede der Vielzahl konfokaler Resonatorzellen (1, 2, 3, 4, 5, 6, 7, 8, 9, 10, 11, 12) einen ersten konkaven sphärischen Spiegel (20, 22, 20, 22), der einen Krümmungsradius hat, und einen zweiten konkaven sphärischen Spiegel (21, 23, 21, 23) umfasst, der den gleichen Krümmungsradius hat und um den Krümmungsradius getrennt ist.

## Revendications

1. Système laser à décharge gazeuse à haute puissance de crête et à courte durée d'impulsion, destiné à produire une impulsion de sortie, comprenant :
un extenseur d'impulsion comprenant :
une optique de déclenchement de retard optique de l'impulsion de sortie laser détournant une partie (1) de l'impulsion de sortie laser, sous la forme d'un faisceau d'entrée, et la transformant en un retard optique présentant un parcours de retard optique ;
**caractérisé en ce que :**
ledit retard optique comprend :
plusieurs cellules de résonateurs confocaux (1, 2, 3, 4, 5, 6, 7, 8, 9, 10, 11, 12) alignées en série pour transmettre une sortie du retard optique à l'optique de déclenchement de retard optique de l'impulsion de sortie laser ;
dans lequel la première cellule de résonateur confocal (1, 2, 3) desdites cellules de résonateurs confocaux (1, 2, 3, 4, 5, 6, 7, 8, 9, 10, 11, 12) comprend :
un premier miroir sphérique concave (20) possédant un rayon de courbure, recevant le faisceau d'entrée de l'optique de déclenchement de retard optique de l'impulsion de sortie laser, comprenant la partie (1) de l'impulsion de sortie laser en un premier point (1) sur une face du premier miroir sphérique concave (20), et générant un premier faisceau réfléchi (2) ;
un second miroir sphérique concave (21) présentant le même rayon de courbure et séparé du premier miroir sphérique concave (20) par le rayon de courbure, et recevant le premier faisceau réfléchi (2) en un premier point sur une face du second miroir sphérique concave (20), et générant un second faisceau réfléchi (3) incident à un second point (3) d'une face du premier miroir sphérique concave (20), ledit second faisceau (3) étant réfléchi par le premier miroir sphérique concave (20) à partir du second point (3) présent sur le premier miroir (20), de façon à former un faisceau de sortie (1a) à partir de la première cellule de résonateur confocal (1, 2, 3) ; et
une seconde cellule de résonateur confocal (4, 5, 6) recevant le faisceau de sortie (1a) de la première cellule de résonateur confocal (4, 5, 6) en tant que faisceau d'entrée de la seconde cellule de résonateur confocal (4, 5, 6).

2. Dispositif selon la revendication 1, dans lequel :
lesdites cellules de résonateurs confocaux comportent quatre cellules de résonateurs confocaux constituées d'une disposition à douze passages et quatre miroirs.

3. Dispositif selon la revendication 1, dans lequel :
chacune desdites cellules de résonateurs confocaux (1, 2, 3, 4, 5, 6, 7, 8, 9, 10, 11, 12) comporte un premier miroir sphérique concave (20, 22, 20, 22) possédant un rayon de courbure et un second miroir sphérique concave (21, 23, 21, 23) possédant le même rayon de courbure, et séparés par le rayon de courbure.

4. Dispositif selon l'une quelconque des revendications 1 à 3, comportant en outre :
un second extenseur d'impulsion comportant :
une seconde optique de déclenchement de retard optique de l'impulsion de sortie laser détournant une partie de l'impulsion de sortie du premier extenseur d'impulsion et la transformant en un second retard optique présentant un parcours de retard optique, et comprenant :
un second ensemble de plusieurs cellules de résonateurs confocaux alignées en série pour transmettre une sortie du second retard optique à la seconde optique de déclenchement de retard optique de l'impulsion de sortie laser.

5. Procédé de production d'une impulsion de sortie d'un laser à décharge gazeuse à haute puissance de crête et à courte durée d'impulsion, comportant une étape d'extension d'une impulsion de sortie
**caractérisé en ce que :**
ladite étape d'extension de l'impulsion de sortie comporte l'étape de détournement d'une partie de l'impulsion de sortie laser vers un parcours de retard optique (1, 2, 3, 4, 5, 6, 7, 8, 9, 10, 11, 12), comportant :
plusieurs cellules de résonateurs confocaux (1, 2, 3, 4, 5, 6, 7, 8, 9, 10, 11, 12) alignées en série pour transmettre la sortie du trajet de retard optique à l'optique de déclenchement de retard optique de l'impulsion de sortie laser et la combiner avec l'impulsion de sortie laser ; dans lequel l'étape d'extension de l'impulsion de sortie comporte en outre l'étape :
d'utilisation d'une première cellule de résonateur confocal desdites cellules de résonateurs confocaux, comportant :
un premier moyen miroir sphérique concave (20) possédant un rayon de courbure, et recevant un faisceau d'entrée (1) de l'optique de déclenchement de retard optique de l'impulsion de sortie laser, comprenant la partie de l'impulsion de sortie laser en un premier point (1) sur une face du premier moyen miroir sphérique concave (20), et générant un premier faisceau réfléchi (2) ;
un second moyen miroir sphérique concave (21) présentant le même rayon de courbure et séparé du premier moyen miroir sphérique concave (20) par le rayon de courbure, et recevant le premier faisceau réfléchi (2) en un premier point (2) sur une face du second miroir sphérique concave (21), et générant un second faisceau réfléchi (3) incident à un second point (3) de la face du premier moyen miroir sphérique concave (20), le second faisceau (3) étant réfléchi par le premier moyen miroir sphérique concave (20) à partir du second point (3) présent sur le premier miroir (20), de façon à former un faisceau de sortie (1a) à partir de la première cellule de résonateur confocal (1, 2, 3) ; et
un second moyen cellule de résonateur confocal (4, 5, 6) recevant le faisceau de sortie (1a) du premier moyen cellule de résonateur confocal (1, 2, 3) en tant que faisceau d'entrée du second moyen cellule de résonateur confocal (4, 5, 6).

6. Procédé selon la revendication 5, dans lequel :
lesdites cellules de résonateurs confocaux comportent quatre cellules de résonateurs confocaux (1, 2, 3, 4, 5, 6, 7, 8, 9, 10, 11, 12) constituées d'une disposition à douze passages et quatre miroirs (20, 21, 22, 23).

7. Procédé selon les revendications 5 ou 6, dans lequel:
chacune desdites cellules de résonateurs confocaux (1, 2, 3, 4, 5, 6, 7, 8, 9, 10, 11, 12) comporte un premier miroir sphérique concave (20, 22, 20, 22) possédant un rayon de courbure et un second miroir sphérique concave (21, 23, 21, 23) possédant le même rayon de courbure, et séparés par le rayon de courbure.
